**Europäisches Patentamt**

**European Patent Office**

(19)

**Office européen des brevets**

(11) Veröffentlichungsnummer : **0 560 168 B1**

(12)

# EUROPÄISCHE PATENTSCHRIFT

(45) Veröffentlichungstag der Patentschrift :
26.07.95 Patentblatt 95/30

(51) Int. Cl.$^6$ : **G01R 33/56**

(21) Anmeldenummer : **93103238.7**

(22) Anmeldetag : **01.03.93**

(54) **Pulssequenz für ein Kernspinresonanzgerät.**

(30) Priorität : **12.03.92 DE 4207930**
**10.08.92 DE 4226446**

(43) Veröffentlichungstag der Anmeldung :
**15.09.93 Patentblatt 93/37**

(45) Bekanntmachung des Hinweises auf die
Patenterteilung :
**26.07.95 Patentblatt 95/30**

(84) Benannte Vertragsstaaten :
**DE ES FR GB IT**

(56) Entgegenhaltungen :
**WO-A-90/00743**
**DE-A- 035 410**
**DE-A- 3 823 398**

(56) Entgegenhaltungen :
**MAGNETIC RESONANCE IMAGING Bd. 6,
1988, Seiten 391 - 395 J. HENNING, H. FRIED-
BURG 'Clinical Applications and Methodological Developments of the RARE Technique'
JOURNAL OF MAGNETIC RESONANCE, Bd.
78, Nr. 3, Juli 1988, DULUTH, USA Seiten 397 -
407 J. HENNING 'Multiecho Imaging Sequences with Low Refocusing Flip Angles'**

(73) Patentinhaber : **SIEMENS
AKTIENGESELLSCHAFT
Wittelsbacherplatz 2
D-80333 München (DE)**

(72) Erfinder : **Heid, Oliver
Haagstrasse 12
W-8520 Erlangen (DE)**
Erfinder : **Deimling, Michael, Dr.
Am Steinbruch 2
W-8521 Möhrendorf (DE)**

**Beschreibung**

Die Erfindung betrifft eine Pulssequenz zum Betrieb eines Kernspinresonanzgeräts. Bei der Kernspintomographie sind kurze Bildaufnahmezeiten von besonderer Bedeutung. Dies gilt nicht nur in Hinblick auf einen möglichst hohen Patientendurchsatz, sondern z.B. auch zur Vermeidung von Bewegungsartefakten. Für bestimme Aufnahmetechniken, z.B. Cine-mode (Aufnahme bewegter Bilder), sind kurze Bildaufnahmezeiten unumgänglich.

Von den bisher bekannten Methoden können mit dem EPI-Verfahren die kürzesten Bildaufnahmezeiten (30 bis 100 ms) erzielt werden. Das EPI-Verfahren ist beispielsweise in der europäischen Patentschrift 0 076 054 beschrieben.

Dabei wird zu Beginn der Pulssequenz ein HF-Anregungspuls RF unter Einwirkung eines Schichtselektionsgradienten in einer ersten Richtung auf ein Untersuchungsobjekt eingestrahlt. Damit werden Kernspins in einer Schicht des Untersuchungsobjektes angeregt. Nach der Anregung wird ein Phasencodiergradient in einer zweiten Richtung und ein Auslesegradient in einer dritten Richtung eingeschaltet. Erste, zweite und dritte Richtungen stehen senkrecht aufeinander. Der Auslesegradient besteht aus einem Vorphasierpuls sowie aus Teilimpulsen von wechselnder Polarität. Durch diese wechselnde Polarität des Auslesegradienten werden die Kernspins im Wechsel dephasiert und wieder rephasiert, so daß eine Folge von Kernspinresonanzsignalen entsteht. Dabei werden nach einer einzigen Anregung soviele Signale gewonnen, daß der gesamte Fourier-k-Raum abgetastet wird, d.h. daß die vorliegenden Informationen zur Rekonstruktion eines vollständigen Schnittbildes ausreichen.

Bei jedem Wechsel der Polarität des Auslesegradienten wird der Phasencodiergradient kurzzeitig eingeschaltet. Damit wird jedesmal die Phasenlage der Kernspins um eine Stufe weitergeschaltet.

Die entstehenden Kernresonanzsignale werden im Zeitbereich abgetastet, digitalisiert und die so gewonnenen numerischen Werte in eine Rohdatenmatrix eingetragen. Aus dieser Rohdatenmatrix wird dann aufgrund einer zweidimensionalen Fouriertransformation ein Bild des Untersuchungsobjektes rekonstruiert.

Der Geschwindigkeitsvorteil des EPI-Verfahrens beruht im wesentlichen darauf, daß nach einer einzelnen Anregung eine Vielzahl von Signalen gewonnen wird, die zur Rekonstruktion eines vollständigen Schnittbildes ausreichen. Sämtliche Signale, die letztlich Gradientenechos darstellen, müssen innerhalb des T2∗-Zerfalls gewonnen werden. Daher muß der Auslesegradient sehr schnell bipolar geschaltet werden, so daß an die Anlage erhebliche technologische Anforderungen gestellt werden.

Ferner haben Gradientenechos, wie sie auch beim EPI-Verfahren erzeugt werden, gegenüber Spinechos den Nachteil, daß sie gegen lokale Feldinhomogenitäten empfindlich sind.

Unter der Bezeichnung "RARE" ist ferner eine schnelle Bildgebungssequenz bekannt, bei der nach einem 90°-Puls durch mehrere aufeinanderfolgende 180°-Pulse Echosignale erzeugt werden. Mit der Folge von 180°-Pulsen ist jedoch eine starke Hochfrequenzbelastung des Patienten verbunden. Um diese Hochfrequenzbelastung zu verringern, wurde in dem Artikel J. Hennig, H. Friedburg," Clinical Applications and Methodological Developments of the RARE Technique", Magnetic Resonance Imaging, Band 6 (1988), Seiten 391 bis 395, vorgeschlagen, zur Refokussierung Hochfrequenzpulse mit einem Flip-Winkel kleiner als 180°, z.B. 60°, zu verwenden. Dabei werden nach jedem Refokussierungspuls Kernresonanzsignale unter einem read-out-Gradienten ausgelesen. Nach jedem Refokussierungspuls wird ferner ein Phasencodiergradient eingeschaltet, wobei die Phasencodierung vor dem nächsten Refokussierungspuls wieder zurückgesetzt wird.

Mit diesem Verfahren ist lediglich eine Reduzierung der Hochfrequenzbelastung im Vergleich zum klassischen "RARE"-Verfahren möglich, jedoch keine Beschleunigung der Datenakquisition.

Aus der DE-C2-38 23 398 ist eine Pulssequenz bekannt, bei der zur Anregung einer Probe eine Folge von vielen äquidistanten HF-Pulsen, ein sogenannter Puls-Burst eingestrahlt wird. Die HF-Pulse weisen einen äußerst kleinen Flip-Winkel in der Größenordnung von 0,1° bis 2° auf. Im Anschluß an die Folge der HF-Pulse wird ein Zug von äquidistanten Echosignalen mit möglichst konstanter Amplitude erhalten. Um die Amplitude der Echosignale möglichst konstant zu halten, werden Amplitude und Phase der HF-Pulse beeinflußt. Für die Bildgebung sind eine selektive Anregung bzw. Refokussierung sowie Auslese- und Phasencodiergradienten vorgesehen.

Ferner ist die Möglichkeit erwähnt, aus der äquidistanten Folge von HF-Pulsen eine mehr oder minder große Anzahl von HF-Pulsen auszulassen. Nach Angabe in der genannten Patentschrift kann eine Minimalisierung der Anzahl der HF-Pulse erreicht werden, wenn der Abstand zwischen den HF-Pulsen entsprechend der Folge 1, 3, 5, 9, 17....n mit $n = 2^{m-1} + 1$ variiert wird. Das Auslassen von HF-Pulsen in der Folge von prinzipiell äquidistanten HF-Pulsen wird jedoch als nachteilig dargestellt, da die Amplitudenkonstanz der Echosignale sehr viel schwerer zu optimieren ist als bei einem Puls-Burst aus einer lückenlosen Folge von HF-Pulsen.

Die in der genannten Patentschrift angegebene nichtäquidistante Hochfrequenz-Pulsfolge hat ferner den Nachteil, daß in der Auslesephase jeweils mehrere Echos zusammenfallen, so daß eine saubere Auswertung zur Bildgewinnung praktisch nicht möglich ist. Außerdem wird durch die kleinen Flipwinkel bei der Anregung das Signal/Rausch-Verhältnis sehr ungünstig.

Aufgabe der Erfindung ist es daher, eine Pulssequenz zum Betrieb eines Kernspinresonanzgerätes derart auszugestalten, daß kurze, mit dem EPI-Verfahren vergleichbare Bildaufnahmezeit erreicht werden, wobei die technologischen Anforderungen an das Kernspinresonanzgerät, insbesondere hinsichtlich der Gradientenelektronik, gering bleiben.

Diese Aufgabe wird erfindungsgemäß gelöst durch die Merkmale des Anspruches 1 bzw. in einer Alternative durch die Merkmale des Anspruches 2. Hierbei können nach K+1 HF-Pulsen bis zu $3^k$ Kernresonanzsignale gewonnen werden. Damit können mit einer verhältnismäßig kleinen Anzahl von Hochfrequenzpulsen in einer Auslesephase genügend Signale zur Abtastung des gesamten k-Raumes gemessen werden. Ferner können reine Spinechos gewonnen werden, die im Vergleich zu Gradientenechos unempfindlich gegen lokale Feldinhomogenitäten sind.

In einer besonders vorteilhaften Ausführungsform steigen die Gradientenflächen zwischen je zwei Anregepulsen, der Größe nach sortiert, mindestens mit dem Faktor 3. Dadurch wird sichergestellt, daß die entstehenden Echos getrennt sind. Damit werden Störungen durch Überlagerung von Echos vermieden und für eine gegebene Zeit der Anregephase erhält man die maximale Anzahl von Echos. Bei einer vorgegebenen Anzahl von Echosignalen kann die Anregephase am kürzesten gewählt werden, wenn die Gradientenfläche exakt nach der Funktion $3^n$ steigt.

Eine Skalierung der unterschiedlichen Amplituden der entstehenden Kernresonanzsignale kann durchgeführt werden, indem man Referenzwerte ohne Phasencodierung gewinnt. Dazu können in einer vorteilhaften Ausführungsform zwei Sätze von Kernresonanzsignalen gewonnen werden, wovon nur ein Satz phasencodiert ist und wobei der nicht phasencodierte Satz von Kernresonanzsignalen als Referenzwert für die Signalamplitude verwendet wird. Um die Datenaufnahmezeit für den nicht phasencodierten Satz von Kernresonanzsignalen zu reduzieren, können in einer vorteilhaften Ausgestaltung unter Ausnutzung von Symmetrien im Amplitudenverlauf der Kernresonanzsignale nur so viele nicht phasencodierte Kernresonanzsignale gewonnen werden, wie für eine Erfassung der Amplitudenverteilung notwendig sind.

Nach einer Anregephase (A) können mehrere Auslesephasen (B1, B2) durchgeführt werden, indem nach der ersten Auslesephase mindestens ein weiterer 180°-HF-Puls eingeschaltet wird und nach jedem weiteren 180°-HF-Puls während jeweils einer weiteren Auslesephase Kernresonanzsignale unter einem Auslesegradienten erfaßt werden, der zumindest eine Komponente in der ersten Richtung aufweist. Alternativ kann nach der ersten Auslesephase der Auslesegradient mindestens einmal umgekehrt werden und während mindestens einer weiteren Auslesephase Kernresonanzsignale unter der Wirkung des Auslesegradienten erfaßt werden.

Weitere vorteilhafte Ausgestaltungen der Erfindung sind in den Unteransprüchen angegeben.

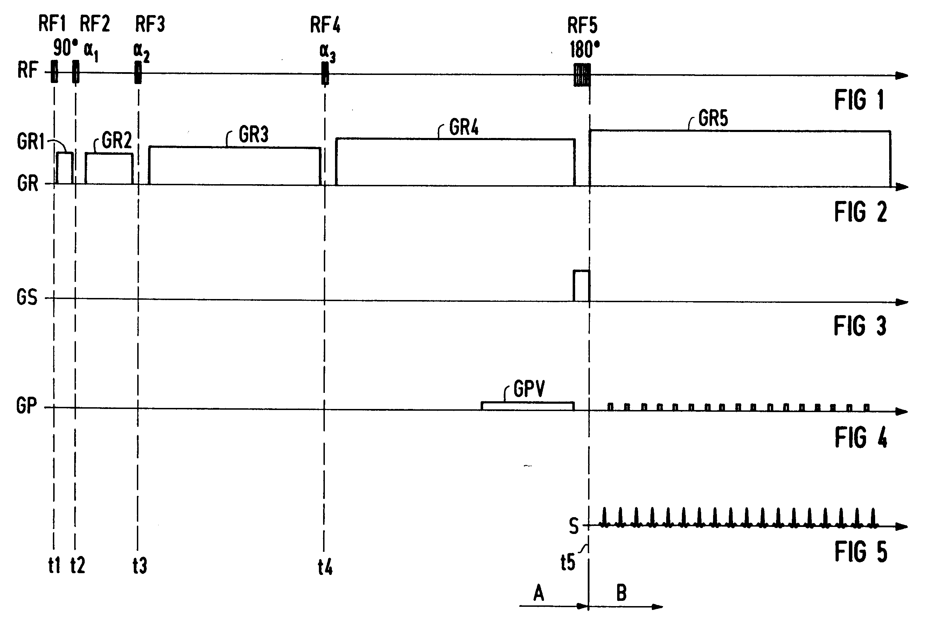

Ausführungsbeispiele der Erfindung werden nachfolgend anhand der Figuren 1 bis 43 näher erläutert. Dabei zeigen:

| | |
|---|---|
| FIG 1 | die HF-Pulse RF, |
| FIG 2 | den Auslesegradienten GR, |
| FIG 3 | den Schichtselektionsgradienten GS, |
| FIG 4 | den Phasencodiergradienten GP, |
| FIG 5 | die entstehenden Kernresonanzsignale S, |
| FIG 6 | den Phasenverlauf der Kernspins bei Anwendung einer Pulssequenz nach den FIG 1 bis 4, |
| FIG 7 | ein Beispiel für den tatsächlichen Verlauf des Kernresonanzsignals in der Auslesephase B, |
| FIG 8 | das Schema einer Rohdatenmatrix, |
| FIG 9 bis 13 | ein Ausführungsbeispiel, bei dem die Phasencodierung während der Anregephase A erfolgt, |
| FIG 14 bis 18 | ein Ausführungsbeispiel, bei dem auch während der Anregephase (A) schon Kernresonanzsignale ausgelesen werden, |
| FIG 19 bis 23 | ein Ausführungsbeispiel, bei dem anstelle eines 180°-Pulses eine Umkehr des Auslesegradienten erfolgt, |
| FIG 24 bis 28 | ein erstes Ausführungsbeispiel für eine Pulssequenz zur Erzeugung eines dreidimensionalen Bildes, |
| FIG 29 bis 32 | ein zweites Ausführungsbeispiel für eine Pulssequenz zur Erzeugung eines dreidimensionalen Bildes, |
| FIG 33 bis 37 | ein Ausführungsbeispiel, bei dem nach einer Anregephase A durch Anwendung eines weiteren 180°-Hochfrequenz-Pulses zwei Auslesephasen B1, B2 folgen, |

FIG 38 bis 42      ein Ausführungsbeispiel, bei dem durch Umkehrung des Auslesegradienten nach einer Anregephase A zwei Auslesephasen B1, B2 folgen und

FIG 43      ein Flußdiagramm für die Skalierung der Signalamplituden.

Beim Ausführungsbeispiel nach FIG 1 werden während einer Anregephase A nacheinander vier HF-Pulse RF1, RF2, RF3 und RF4 zu den Zeitpunkten t1, t2, t3 bzw. t4 auf das Untersuchungsobjekt eingestrahlt. Dabei nimmt der Zeitabstand zwischen zwei HF-Pulsen RF von HF-Puls zu HF-Puls zu. Wenn die HF-Pulse RF1 bis RF4 einen Flipwinkel von 90° haben, weisen in der nachfolgenden Auslesephase B die Kernresonanzsignale eine maximale Amplitude auf. Um in später noch zu erörtender Weise die Amplitudenverteilung der Kernresonanzsignale zu verbessern, kann es jedoch günstiger sein, wenn nur der erste HF-Puls RF1 einen Flipwinkel von 90° hat und die übrigen HF-Pulse RF2 bis RF4 einen Flipwinkel zwischen 60° und 90° aufweisen. Jedenfalls ist es für das Signal/Rausch-Verhältnis günstig, wenn die Summe der Flipwinkel aller HF-Pulse wesentlich über 180° liegt. Zu einem Zeitpunkt t5 folgt ein weiterer HF-Puls RF5 mit einem Flipwinkel von 180°. Damit wird das gesamte vorher angeregte Spinsystem in der Phase invertiert. Der HF-Puls RF5 ist frequenzselektiv. Da gleichzeitig ein Schichtselektionsgradient GS gemäß FIG 3 eingeschaltet wird, wirkt der HF-Puls RF5 nur auf eine Schicht des Untersuchungsobjektes.

Gemäß FIG 2 sind zwischen jeweils zwei HF-Pulsen RF1 bis RF5 Gradienten GR1 bis GR4 in Auslese-Richtung eingeschaltet.

Während der auf den Hochfrequenzpuls RF5 folgenden Auslesephase ist ebenfalls ein Gradient GR5 in Ausleserichtung eingeschaltet.

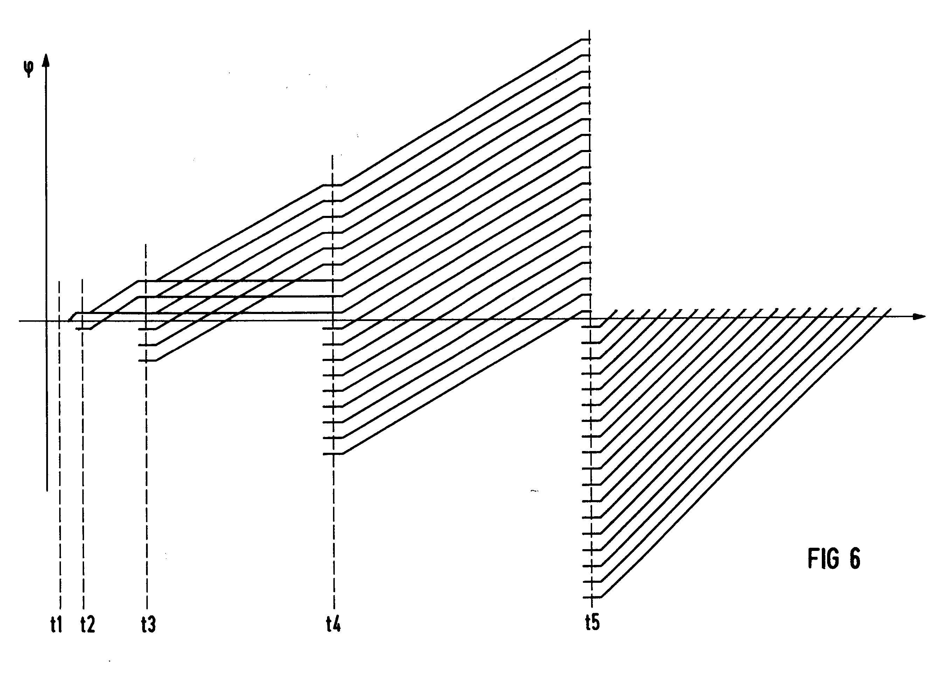

Der Phasenverlauf der Spins, der sich aufgrund der HF-Pulse RF1 bis RF5 nach FIG 1 sowie unter der Einwirkung der Gradientenpulse GR1 bis GR5 ergibt, ist in FIG 6 dargestellt. Um den zeitlichen Zusammenhang zwischen der Darstellung nach FIG 6 und der Pulssequenz nach den FIG 1 bis 5 herzustellen, sind in FIG 6 ebenfalls die Zeitpunkte t1 bis t5 eingetragen.

Die Phase der zum Zeitpunkt t1 mit dem HF-Puls RF1 angeregten Spins nimmt unter der Wirkung des Gradienten GR1 zunächst kontinuierlich zu. Zum Zeitpunkt T2 wirkt auf die bereits angeregten Spins nochmals ein HF-Puls RF2. Damit wird die mit dem HF-Puls RF1 erzeugte primäre Spinmagnetisierung nach dem Partitionsmodell von Woessner (beschrieben in J. Chem. Phys. 34, 2057, 1961) bezüglich der Phase in drei Komponenten aufgespalten: Zum Teil wird die Phase invertiert, zum Teil bleibt sie unverändert und zum Teil wird die Magnetisierung in eine durch Gradienten nicht beeinflußbare z-Lage gebracht. Diese drei Komponenten der Spin-Magnetisierung werden zum Zeitpunkt t3 wiederum einer Anregung mit dem dritten HF-Puls RF3 unterworfen. Für alle drei Komponenten der Spinmagnetisierung erfolgt damit wieder eine Aufteilung in die oben genannten drei Komponenten, so daß nun insgesamt neun verschiedene Komponenten der Spinmagnetisierung vorliegen. Zum Zeitpunkt t4 erfolgt durch einen weiteren HF-Puls RF4 nochmals eine Aufspaltung aller Komponenten in jeweils drei weitere Komponenten. Damit steht zum Zeitpunkt t5 achtzehn Komponenten unterschiedlicher Phasenlage zur Verfügung. Dabei wurden die durch die Hf-Pulse RF2 bis RF4 erzeugten FID-Signale der Übersichtlichkeit wegen nicht betrachtet. Auch diese Signale können für die Bilderzeugung herangezogen werden. Zum Zeitpunkt t5 werden durch den 180°-HF-Puls RF5 alle Spinmagnetisierungen invertiert. Dies gilt wegen der selektiven Aufschaltung des 180°-HF-Pulses RF5 allerdings nur für die selektierte Schicht.

Nach dem HF-Puls RF5 nehmen die Phasen der einzelnen Komponenten der Spinmagnetisierung unter der Wirkung des gleichzeitig eingeschalteten Gradienten GR5 wieder linear zu. Wie in FIG 6 sichtbar, weisen die einzelnen Komponenten der Spinmagnetisierung zu unterschiedlichen Zeitpunkten einen Phasennulldurchgang auf. Der Phasennulldurchgang ist gleichbedeutend mit einer Fokussierung, bei der ein Kernresonanzsignal entsteht. Die während der Auslesephase B entstehenden Kernresonanzsignale sind in FIG 5 abgebildet. Damit wurden also mit vier HF-Anregungspulsen RF1 bis RF4 sowie einem 180°-HF-Puls RF5 achtzehn Signale erzeugt. Allgemein gesprochen erfolgt dies durch Aufspalten der jeweils vorhandenen Spinmagnetisierung durch die nach dem ersten Anregungspuls folgenden Anregungspulse und zeitlich gestaffelte Fokussierung der damit entstehenden einzelnen Teilkollektive. Die entstehenden Signale enthalten aufgrund des während der Auslesephase eingeschalteten Read-Out-Gradienten GR5 eine Phaseninformation bezüglich der Richtung des Read-Out-Gradienten GR5. Durch die Schichtselektivität des 180°-HF-Pulses RF5 ist bereits eine örtliche Vorselektion auf eine bestimmte Schicht erfolgt. Der Read-Out-Gradient GR5 steht zweckmäßigerweise senkrecht auf dem Schichtselektionsgradienten GS, so daß mit dem Read-Out-Gradienten GR5 eine Codierung bezüglich einer Richtung innerhalb der selektierten Schicht bezüglich der Phasenlage erfolgt.

Zur dreidimensionalen Ortsauflösung muß noch eine Phasencodierung in einer dritten Raumrichtung erfolgen. Dazu kann gemäß FIG 4 zwischen den Signalen jeweils ein Einzelpuls eines Phasencodiergradienten GP eingeschaltet werden, so daß eine Phasencodierung bezüglich der Richtung des Phasencodiergradienten, die zweckmäßigerweise senkrecht bezüglich der Richtungen des Read-Out-Gradienten GR5 und des Schichtselektionsgradienten GS liegt, erfolgt. Damit der Nulldurchgang der Phasencodierung in der mittleren Zeile der nachfolgend noch erläuterten Rohdatenmatrix liegt, ist in der Anregephase A ein Vorphasierpuls GPV vorgesehen. Die Wirkung dieses Vorphasierpulses GPV wird durch den 180°-HF-Puls RF5 invertiert, so daß eine negative Vorphasierung entsteht, deren Wirkung durch die Einzelpulse des Phasencodiergradienten GP während der Auslesephase B schrittweise wieder aufgehoben wird. Die Fläche des Vorphasierpulses GPV ist so dimensioniert, daß diese gleich der Summe der Einzelpulse GP bis zur Mitte der Auslesephase B ist.

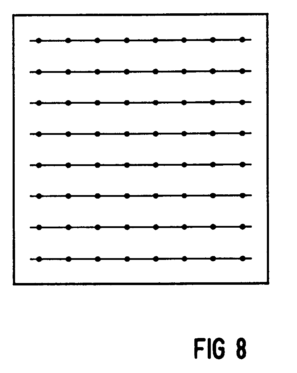

Die in FIG 5 dargestellten Kernresonanzsignale S werden im Zeitbereich abgetastet, digitalisiert und die so gewonnenen numerischen Werte in eine Rohdatenmatrix gemäß FIG 8 eingetragen. Die Rohdatenmatrix kann man als Meßdatenraum, bei dem im Ausführungsbeispiel vorliegenden zweidimensionalen Fall als Meßdatenebene betrachten. Diese Meßdatenraum wird in der Kernspintomographie im allgemeinen als "k-Raum" bezeichnet.

Die für die Bilderzeugung notwendige Information über die räumliche Herkunft der Signalbeiträge S ist in den Phasenfaktoren codiert, wobei zwischen dem Ortsraum (also dem Bild) und dem k-Raum mathematisch der Zusammenhang über ein zweidimensionale Fourier-Transformation besteht. Es gilt:

$$S(k_x, k_y) = \iint \mathcal{S}(x, y)\, e^{i(k_x x + k_y y)}\, dx\, dy \; .$$

Dabei gelten folgende Definitionen:

$$k_x(t) = \gamma \int_0^t G_x(t')\, dt'$$

$$k_y(t) = \gamma \int_0^t G_y(t')\, dt' \; .$$

$\gamma$ = gyromagnetisches Verhältnis
$G_x(t')$ = Momentanwert des Auslesegradienten GR5
$G_y(t')$ = Momentanwert des Phasencodiergradienten PC.

Bei der in FIG 8 dargestellten Rohdatenmatrix entspricht jede Zeile einem Einzelsignal S.

Durch die schrittweise Fortschaltung des Phasencodiergradienten GP gemäß FIG 4 erfolgt die Abtastung im k-Raum in aufeinanderfolgenden Zeilen, beginnend mit der Zeile O. Würde man den Phasencodiergradienten GP während der Auslesephase eingeschaltet lassen, so würde im k-Raum eine "schräg" liegende Abtastung erfolgen.

Aus der in FIG 8 dargestellten Rohdatenmatrix wird durch zweidimensionale Fouriertransformation eine Bildmatrix gewonnen, aufgrund derer dann eine Bildrekonstruktion erfolgt.

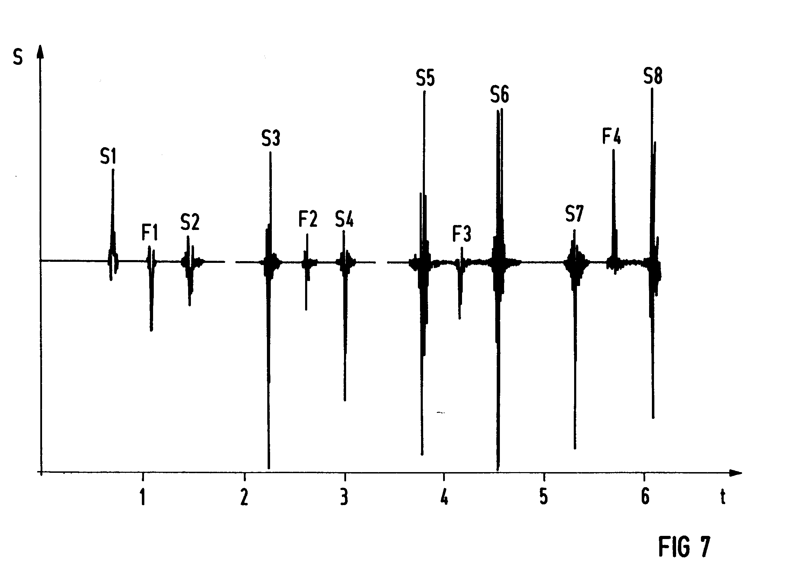

In FIG 7 sind die während der Auslesephase entstehenden Signale, die in FIG 5 nur schematisch dargestellt sind, anhand eines tatsächlich erstellten Plots gezeigt. Die ausgewerteten Signale sind dabei mit S1 bis S8 bezeichnet, die von den FID-Signalen der Hf-Pulse RF2 bis RF4 herrührenden Signale sind mit F1 bis F4 bezeichnet und werden im dargestellten Ausführungsbeispiel nicht ausgewertet, obwohl dies im Prinzip möglich wäre. Dabei wird deutlich, daß die einzelnen Signale eine unregelmäßige Amplitudenverteilung aufweisen. Ohne weitere Maßnahmen wurde dies zu Artefakten bei der Bildrekonstruktion führen. Tatsächlich ist daher eine Skalierung durch unterschiedliche Abschwächungen bzw. Verstärkungen bei der Signalverarbeitung erforderlich, um eine gleichmäßige Amplitudenverteilung zu erzielen. Derartige Maßnahmen sind jedoch mit Einbußen im Signal-Rauschverhältnis verbunden.

Ohne diesen Nachteil ist eine Verbesserung der Amplitudenverteilung der erzeugten Kernresonanzsignale auch durch Wahl der HF-Pulsstärken der HF-Pulse RF1 bis RF4 sowie deren Phasen möglich. Dabei kann man durch empirisches Vorgehen die Amplitudenverteilung verbessern. Beispielsweise hat sich für vier HF-Pulse eine Flip-Winkel-Verteilung von 90°-75°-75°-90° als günstig erwiesen, damit erhält man die geringste Variation der Echo-Amplituden von 6,96:1.

Die bisherigen Erläuterungen und Figuren bezogen sich der Darstellbarkeit wegen auf vier Anregungspulse RF1 bis RF4. In der Praxis müssen jedoch mehr Anregepulse eingesetzt werden, um die für eine ausreichende Ortsauflösung benötigte Anzahl von Zeilen im k-Raum mit einer einzigen Anrege- und Auslesephase zu erhalten. Typischerweise werden z.B. 128 bzw. 256 Zeilen verwendet, so daß eine entsprechende Anzahl von Signalen S erzeugt werden muß.

Das beschriebene Verfahren stellt geringe Anforderungen an die Gradientenelektronik, da kein schnelles Schalten des Auslesegradienten erforderlich ist. Bei der Ausführungsform nach FIG 4 muß lediglich der Phasencodiergradient GP schnell geschaltet werden. Phasencodiergradienten weisen jedoch im Vergleich zu Auslesegradienten eine wesentlich kleinere Amplitude auf, so daß die Anforderungen an die Gradientenelektronik gering bleiben. Die Aufnahmezeit liegt etwa in dem Bereich des EPI-Verfahrens. Bei dem beschriebenen Ausführungsbeispiel enstehen reine Spinechos, die gegen lokale Feldinhomogenitäten unempfindlich sind.

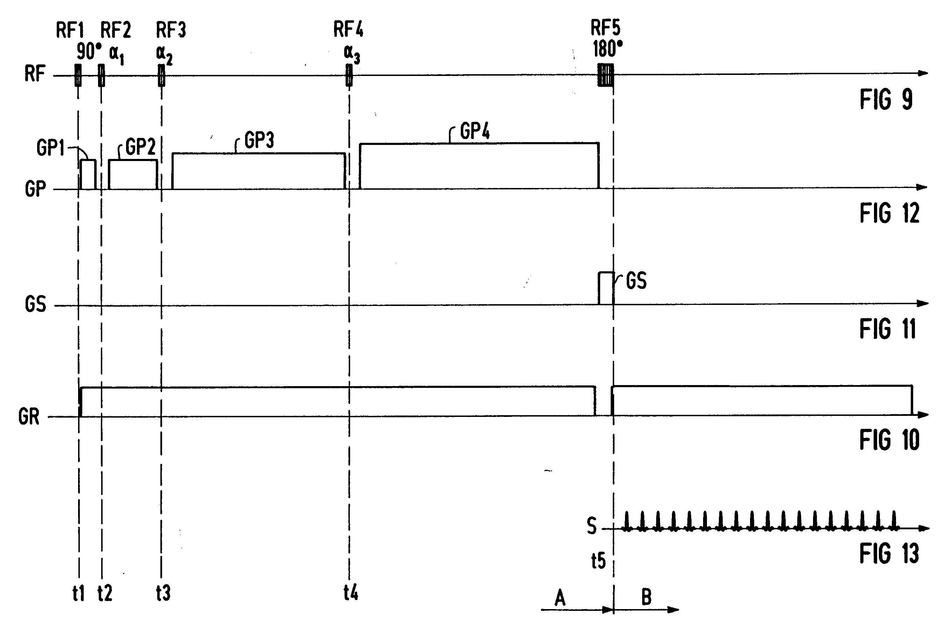

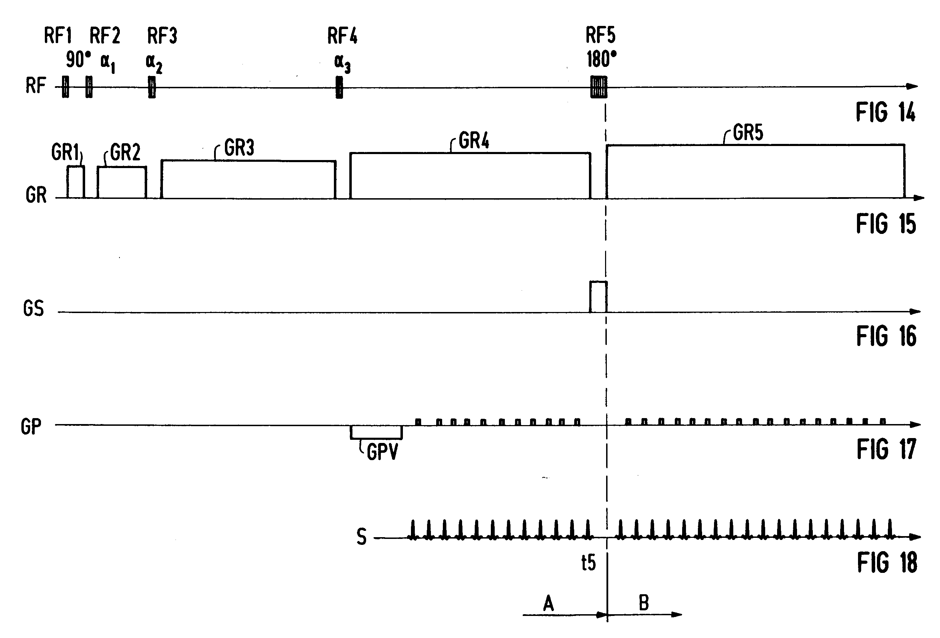

Die Phasencodierung kann auch während der Anregephase erfolgen. Eine entspechende Pulssequenz ist in den FIG 9 bis 13 dargestellt. Im Unterschied zum Ausführungsbeispiel nach den FIG 1 bis 5 ist hierbei während der Anregephase A in den Lücken zwischen jeweils zwei Hf-Pulsen RF1 bis RF5 jeweils ein Einzelpuls GP1 bis GP4 eines Phasencodiergradienten GP eingeschaltet (FIG 12). Während der Auslesephase B ist kein Phasencodiergradient GP mehr eingeschaltet. Da die Kernspins ein "Phasengedächtnis" besitzen, behalten sie die während der Anregephase A aufgeprägte ortsabhängige Phaseninformation auch während der Auslesephase, so daß diese Phaseninformation zur Ortsauflösung ausgewertet werden kann.

Diese Anordnung hat den Vorteil, daß die Schaltzeiten der Einzelpulse des Phasencodiergradienten GP länger werden als beim Ausführungsbeispiel nach den FIG 1 bis 5.

Im Unterschied zum Ausführungsbeispiel nach FIG 2 bleibt bei der Pulssequenz nach FIG 9 der Gradient GR während der gesamten Anregephase mit Ausnahme der Einschaltzeit des Hf-Pulses RF5 eingeschaltet. Um dabei eine unerwünschte Schichtselektion in einer Richtung senkrecht zur Richtung des Gradienten GR zu vermieden, müssen dabei die Hf-Pulse RF1 bis RF4 sehr breitbandig sein.

Wie in FIG 6 sichtbar, erfolgt auch bereits während der Anregephase A ein Nulldurchgang der Phasen der Kernspins, d.h. also eine Rephasierung. Auch hierbei entstehen Kernresonanzsignale, die in FIG 5 jedoch nicht dargestellt sind, da sie in dem dort beschriebenen Ausführungsbeispiel nicht ausgewertet werden. Es ist aber durchaus möglich, auch die während der Anregephase A, insbesondere zwischen den Zeitpunkten t4 und t5 entstehenden Kernresonanzsignale auszuwerten. Ein derartiges Ausführungsbeispiel ist in den Pulsdiagrammen nach den FIG 14 bis 18 dargestellt. Dabei werden die Hochfrequenzpulse RF1 bis RF5, der Auslesegradient GR und der Schichtselektionsgradient GS nach den FIG 14 bis 16 wie beim Ausführungsbeispiel nach den FIG 1 bis 3 geschaltet. In FIG 18 sind im Unterschied zu FIG 5 auch Kernresonanzsignale S während der Anregephase A dargestellt. Um diese Kernresonanzsignale für die räumliche Auswertung heranziehen zu können, müssen auch sie phasencodiert werden. Dazu sind entsprechend FIG 17 auch während der Anregephase A Einzelpulse des Phasencodiergradienten GP vorgesehen. Der Vorphasierpuls GPV muß vor dem ersten dieser Einzelpulse geschaltet werden.

Dabei wird den Kernspins mit den Phasencodiergradienten GP1 bis GP4 eine ortsabhängige Phase aufgeprägt, die zu Beginn der Auslesephase gespeichert ist. Damit weisen alle Signale eine ortsabhängige Phaseninformation auf, die zur Bildberechnung herangezogen wird. Mit dieser Pulssequenz können bei gleichbleibender Meßzeit gegenüber dem Ausführungsbeispiel nach den FIG 1 bis 5 zusätzliche Signale gewonnen werden.

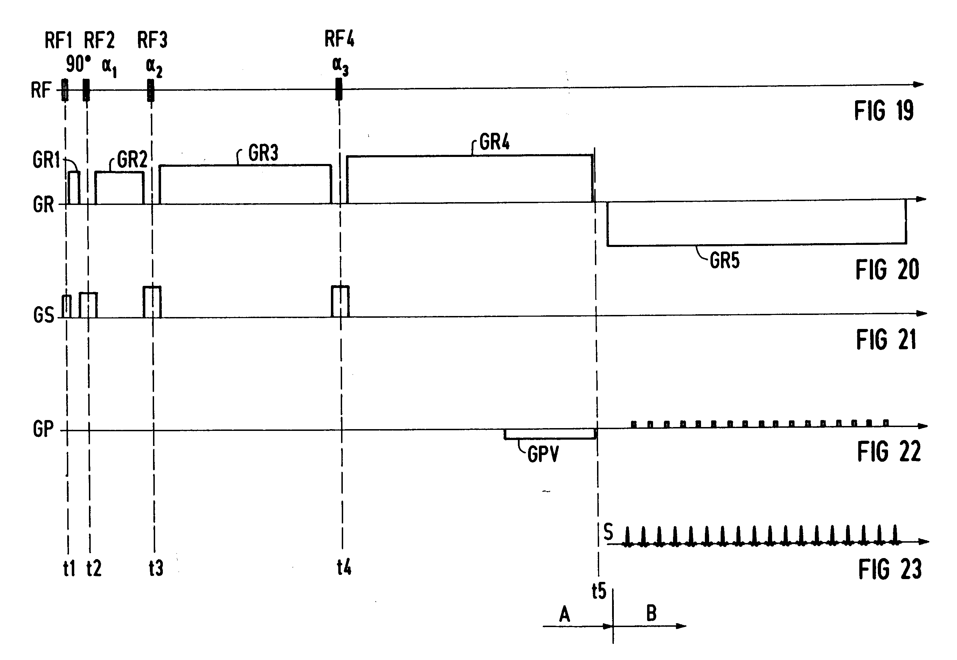

Eine Rephasierung der Kernspins kann nicht nur durch einen 180°-HF-Puls, sondern in bekannter Weise alternativ auch durch eine Gradientenumkehr erreicht werden. Ein Ausführungsbeispiel für eine Pulssequenz mit Gradientenumkehr ist in den FIG 19 bis 23 dargestellt. Bei der Folge von HF-Pulsen RF.. ist hierbei im Unterschied zu FIG 1 der 180°-Puls RF5 weggelassen. Dafür ist die Richtung des Auslesegradienten GR5 bezüglich der Gradienten GR1 bis GR4 invertiert. Damit entstehen die Kernresonanzsignale S nach FIG 23 nicht mehr als Spinechos, sondern als Gradientenechos. Die Auswertung kann jedoch, wie beim Ausführungsbeispiel nach den FIG 1 bis 5 erfolgen.

Wie in FIG 21 dargestellt, wird bei diesem Ausführungsbeispiel ferner der Schichtselektionsgradient GS bei jedem HF-Puls RF1 bis RF4 eingeschaltet. Jeder HF-Puls RF1 bis RF4 ist frequenzselektiv, so daß er unter der Einwirkung des zugeordneten Schichtselektionsgradienten nur auf eine vorgegebene Schicht des Untersuchungsobjektes wirkt. Wie in FIG 22 dargestellt, muß in diesem Ausführungsbeispiel ferner der Vorphasierpuls GPV gegenüber den Einzelpulsen des Phasencodiergradienten GP invertiert werden, da im Unterschied zum Ausführungsbeispiel nach den FIG 1 bis 5 seine Wirkung nicht durch einen 180°-HF-Puls invertiert wird.

Aufgrund der kurzen Meßzeit bietet sich das dargestellte Verfahren zu Gewinnung von dreidimensionaler Bildinformation an. Hierzu muß auch in einer zweiten Richtung eine Phasencodierung erfolgen.

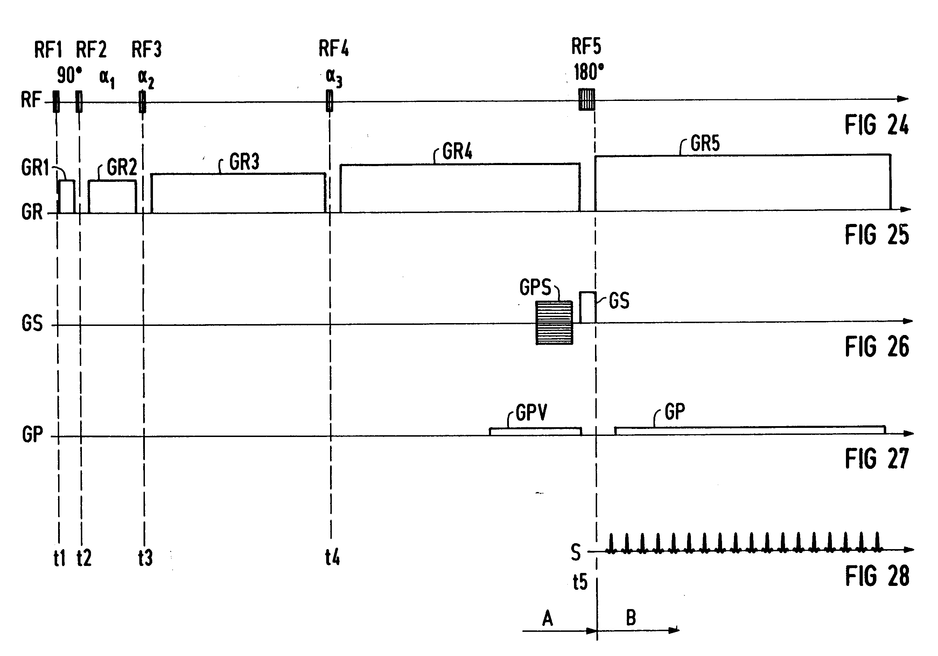

Ein erstes Ausführungsbeispiel für eine Pulssequenz zur Erzeugung einer dreidimensionalen Bildinformation ist in den FIG 24 bis 28 dargestellt. Bezüglich der in FIG 24 dargestellten HF-Pulse RF1 bis RF5 sowie der in FIG 25 dargestellten Gradienten GR1 bis GR5 stimmt diese Pulssequenz mit dem Ausführungsbeispiel nach den FIG 1 und 2 überein. Wie bei FIG 4 ist auch ein Vorphasiergradient in Phasencodierrichtung GPV vorgesehen. Während der Auslesephase bleibt der Phasencodiergradient GP in diesem Ausführungsbeispiel eingeschaltet. Dies hängt nicht notwendigerweise mit der dreidimensionalen Bildgebung zusammen, sondern soll lediglich eine Alternative zur stufenweisen Fortschaltung der Phase nach den FIG 4, 17 und 22 aufzeigen.

Zur Gewinnung einer dreidimensionalen Bildinformation muß die dargestellte Sequenz n-mal mit unterschiedlichen Werten eines Phasencodiergradienten in einer zweiten Richtung wiederholt werden. Dies ist in FIG 26 durch mehrere Stufen des zweiten Phasencodiergradienten GPS angedeutet. Der 180°-HF-Puls RF5 wirkt in diesem Ausführungsbeispiel ebenfalls mit einem Schichtselektionsgradienten GS zusammen. Er darf in diesem Fall jedoch nicht nur auf eine dünne Schicht, sondern auf eine dicke Schicht bzw. Scheibe wirken, innerhalb derer die dreidimensionale Auflösung erfolgen soll. Dies kann durch entsprechende Wahl der Frequenzbandbreite des 180°-HF-Pulses RF5 erreicht werden.

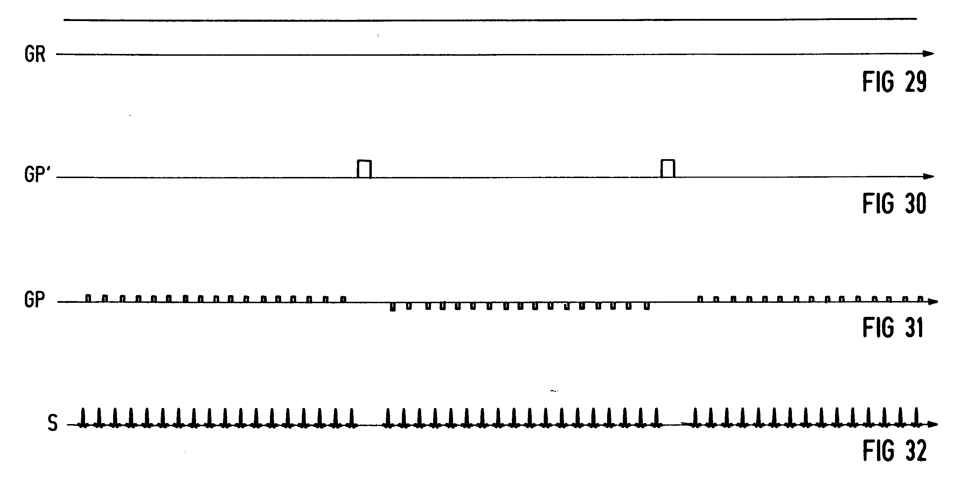

Es ist ferner auch möglich, bereits nach einer einzigen Anregephase genügend Signale zur dreidimensionalen Bildgebung zu gewinnen. Ein derartiges Ausführungsbeispiel ist in den FIG 29 bis 32 dargestellt, wobei hier die Anregephase der Übersichtlichkeit wegen weggelassen ist. Diese kann beispielsweise mit der Anregephase A nach den FIG 1 bis 4 übereinstimmen, wobei jedoch auch hier der 180°-HF-Puls RF5 auf eine dicke Schicht wirken muß, innerhalb derer eine dreidimensionale Auflösung erfolgt.

Beim Ausführungsbeispiel nach den FIG 29 bis 32 wird jeweils nach einer Anzahl von n Signalen S nach FIG 32, die jeweils durch Einzelpulse eines ersten Phasencodiergradienten GP gemäß FIG 31 in einer ersten Richtung phasencodiert sind, ein Phasencodierpuls GP' in einer zweiten Richtung eingeschaltet. Damit wird die Phase der Kernspins in der zweiten Richtung schrittweise verändert. Die Richtung des zweiten Phasencodiergradienten GP' steht senkrecht auf der Richtung des ersten Phasencodiergradienten GP und des Auslesegradienten GR. Nach jedem Puls des zweiten Phasencodiergradienten GP' wird die Richtung der Einzelpulse des ersten Phasencodiergradienten GP invertiert, so daß eine mäanderförmige Abtastung des dreidimensionalen k-Raums erfolgt. Zwischen zwei Einzelpulsen des zweiten Phasencodiergradienten GP' werden jeweils n ∗ m ortscodierte Signale gewonnen. Dies wird p-mal mit aufgrund des zweiten Phasencodiergradienten GP' geschalteter Phase durchgeführt, so daß schließlich eine dreidimensionale n ∗ m ∗ p Rohdatenmatrix zur Verfügung steht, aus der durch dreidimensionale Fouriertransformation ein Bild mit dreidimensionaler Ortsinformation gewonnen werden kann.

Die Tatsache, daß die Auslesephase bei dem beschriebenen Verfahren sehr kurz ist, ermöglicht es, nach einer Anregephase innerhalb des T2∗-Zerfalls der Kernresonanzsignale mehrere Auslesephasen durchzuführen.

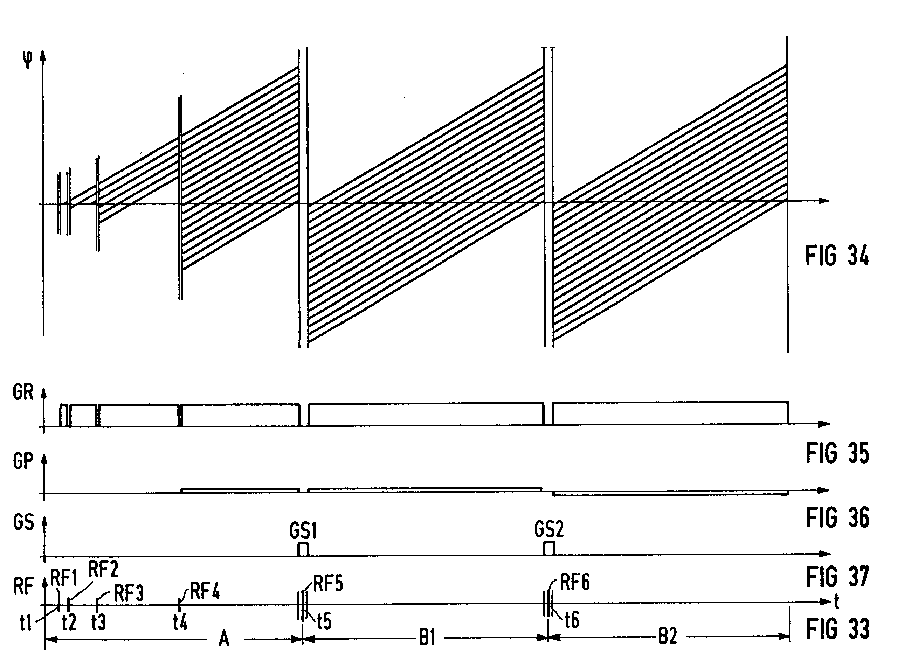

Ein erstes derartiges Ausführungsbeispiel ist in der Pulssequenz nach den FIG 33 bis 37 dargestellt. FIG 33 zeigt die Hochfrequenzpulse RF, FIG 34 zeigt den Phasengang der Kernspins in Analogie zu FIG 6, FIG 35 zeigt den Verlauf des Auslegradienten GR, FIG 36 zeigt den Verlauf des Phasencodiergradienten GP und FIG 37 zeigt den Verlauf des Schichtselektionsgradienten GS. Die entstehenden Kernresonanzsignale sind der Übersichtlichkeit wegen nicht dargestellt.

Bis zum Zeitpunkt t6 entspricht die Pulssequenz derjenigen nach den FIG 1 bis 5 mit Ausnahme des Phasencodiergradienten GP, der in FIG 36 nicht in Blips, sondern kontinuierlich geschaltet wird. Zum Zeitpunkt t6, also nach dem letzten Kernresonanzsignal der Auslesephase B1 wird ein zweiter 180°-Puls RF6 zusammen mit einem Schichtselektionsgradienten GS2 eingeschaltet. Damit werden die Phasenlagen der Kernspins entsprechend der Darstellung nach FIG 34 invertiert. Der zweite 180°-Hochfrequenzpuls RF6 wirkt ebenso wie der erste 180°-Hochfrequenzpuls RF5 schichtselektiv.

Es folgt nunmehr eine zweite Auslesephase B2, in der unter der Wirkung eines Auslesegradienten GR die Phase der Spins entsprechend der Darstellung nach FIG 34 wieder hochläuft. Wie bereits oben erläutert, entsteht bei jedem Nulldurchgang der Phase ein Kernresonanzsignal, das jedoch in den Figuren der Übersichtlichkeit wegen nicht dargestellt ist. Damit können in der zweiten Auslesephase B2 ebensoviele Kernresonanzsignale wie in der ersten Auslesephase B1 gewonnen werden. Während der zweiten Auslesephase B2 ist auch ein Phasencodiergradient GP eingeschaltet, dessen Richtung gegenüber der ersten Auslesephase B1 invertiert ist. Durch entsprechende Dimensionierung des Auslese- und des Phasencodiergradienten GR, GP können Bereiche des k-Raums abgetastet werden, die in der ersten Auslesephase B1 noch nicht erfaßt wurden. Wenn bereits in der ersten Auslesephase B1 der gesamte k-Raum abgetastet wurde, kann aber auch in der Auslesephase B2 derselbe k-Raum nochmals abgetastet werden, z.B. um zeitlich dicht aufeinanderfolgende Bilder derselben Schicht zu gewinnen oder um verschiedene, durch Dimensionierung des Schichtselektionsgradienten GS ausgewählte Schichten abzutasten.

Durch mehrfache Anwendung von 180°-Hochfrequenzpulsen können auch mehr als zwei Auslesephasen B durchgeführt werden.

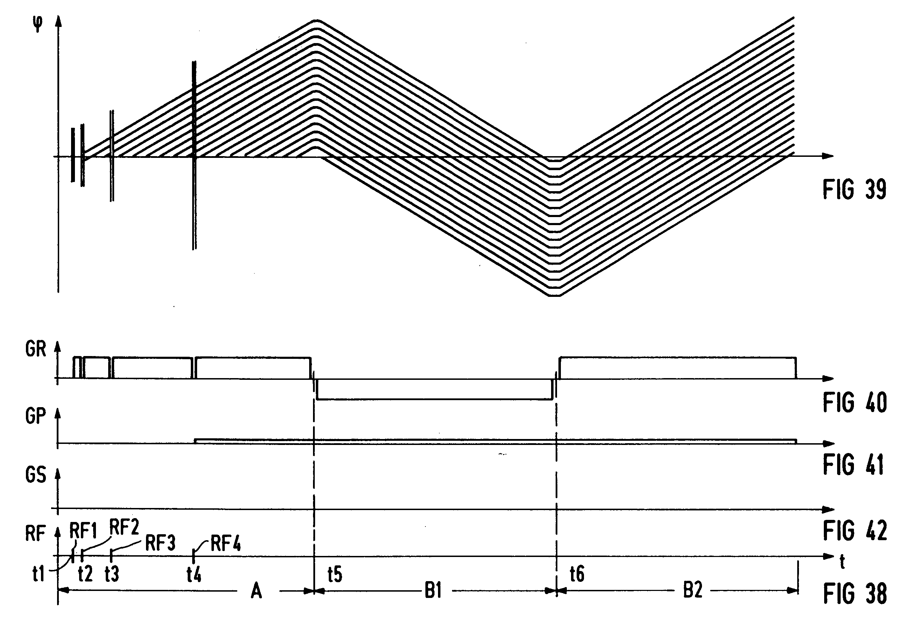

Mehrere Auslesephasen nach einer einzigen Anregephase erhält man auch durch eine Gradientenumkehr mit einer Pulssequenz nach den FIG 38 bis 42. Diese Pulssequenz entspricht bis zum Zeitpunkt t6 der Pulssequenz nach den FIG 19 bis 23, wobei der Phasencodiergradient GP wiederum nicht in Form von Blips, sondern kontinuierlich geschaltet ist. Zum Zeitpunkt t6, also wenn das letzte Kernresonanzsignal der Auslesephase B1 ausgelesen ist, wird die Richtung des Auslesegradienten GR invertiert und die Phasen der Kernspins laufen entsprechend FIG 39 wieder hoch. Damit entstehen wiederum Null-Durchgänge der Phase, bei denen jedesmal ein der Übersichtlichkeit wegen nicht dargestelltes Kernresonanzsignal auftritt. Auch hierbei können in der zweiten Auslesephase B2 genausoviele Kernresonanzsignale gewonnen werden wie in der ersten Auslesephase B1. Auch während der Auslesephase B2 werden die Kernresonanzsignale phasencodiert.

Durch mehrfache Umkehr des Auslesegradienten GR können sich an eine Anregephase A wieder mehr als die zwei im Ausführungsbeispiel nach den FIG 38 bis 39 dargestellten Auslesephasen B anschließen.

In den Figuren wurden die während der Auslesephase entstehenden Signale nur schematisch dargestellt. FIG 7 zeigt anhand eines experimentell erstellten Plots ein Beispiel für den tatsächlichen Signalverlauf. Die ausgewerteten Signale sind dabei mit S1 bis S8 bezeichnet, die von den FID-Signalen der HF-Pulse RF2 bis RF4 herrührenden Signale sind mit F1 bis F4 bezeichnet und werden im dargestellten Ausführungsbeispiel nicht ausgewertet, obwohl dies im Prinzip möglich wäre. Dabei wird deutlich, daß die einzelnen Signale eine unregelmäßige Amplitudenverteilung aufweisen. Ohne weitere Maßnahmen würde dies zu Artefakten bei der Bildrekonstruktion führen. Tatsächlich ist daher eine Skalierung durch unterschiedliche Abschwächungen bzw. Verstärkungen bei der Signalverarbeitung erforderlich, um eine gleichmäßige Amplitudenverteilung zu erzielen.

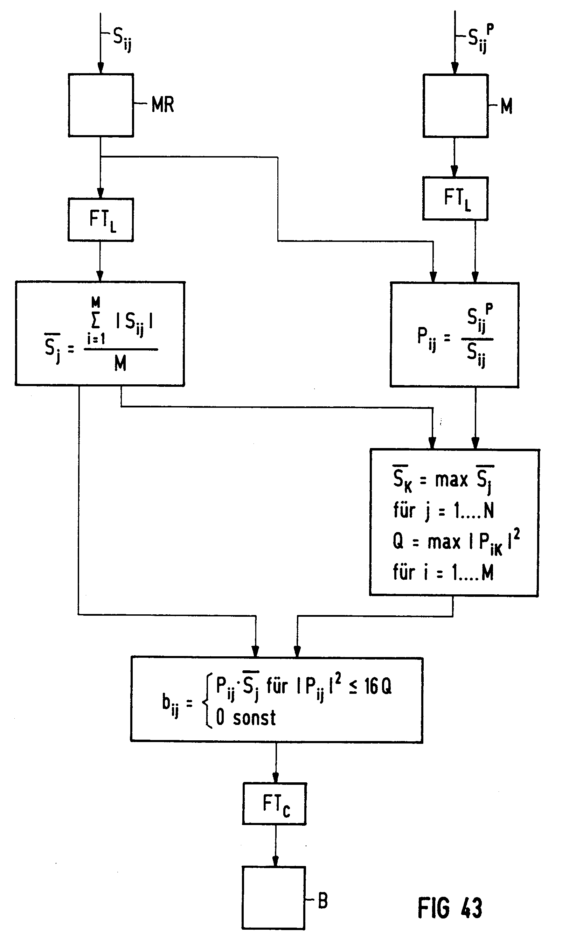

Um die Amplitudenverteilung zu erfassen, kann man zunächst eine Referenzmessung ohne Phasencodiergradient durchführen. Hierfür eignet sich jede der bisher dargestellten Pulssequenzen, wobei der Phasencodiergradient GP weggelassen wird. Die so gewonnenen Referenzsignale kann man in eine Referenzmatrix eintragen. Dieses Vorgehen ist in einem Ablaufschema nach FIG 43 schematisch dargestellt. Dabei sind die nichtphasencodierten Kernresonanzsignale mit $S_{ij}$, die phasencodierten Kernresonanzsignale mit $S_{ij}^P$ bezeichnet. Dabei deutet i auf die Zeilennummer, j auf die Spaltennummer hin. Die Signale $S_{ij}$ werden in eine Meßmatrix MR, die Signale $S_{ij}^P$ werden in eine Meßmatrix M eingetragen. Beide Matrizen werden in Zeilenrichtung (entsprechend der Richtung des Auslesegradienten) Fourier-transformiert, was in FIG 43 mit $FT_L$ bezeichnet ist. Pixelweise wird eine die Phaseninformation der Meßsignale $S_{ij}$ beinhaltende Größe $P_{ij}$ als Quotient aus den phasencodierten Signalen $S_{ij}^P$ und den nichtphasencodierten Signalen $S_{ij}$ gebildet. Ferner wird in der in Zeilenrichtung Fourier-transformierten Meßmatrix eine Mittelung über alle Zeilen i durchgeführt, so daß man bei einer Meßmatrix mit M Zeilen und N Spalten N Signale $\overline{S}_j$

$$\overline{S}_j = \sum_{i=1}^{m} |S_{ij}| / M$$

erhält. Diese Signale entsprechen einem Mittelwert über alle Projektionon. Ferner wird eine Hilfsgröße Q wie folgt gebildet: zunächst sucht man den größten Mittelwert des Signals $\overline{S}_j$, dessen Spaltennummer mit k bezeichnet wird:

$$\overline{S}_k = \max \overline{S}_j \qquad \text{für } j = 1...N.$$

Für diese Zeile k wird der Hilfswert Q wie folgt ermittelt:

$$Q = \max |P_{ik}|^2 \qquad \text{für } i = 1...M.$$

Mit den so gefundenen Größen ermittelt man in einer weiteren Matrix pixelweise Werte $b_{ij}$ nach folgendem Schema:

$$b_{ij} = P_{ij} \cdot \overline{S}_j \text{ für } |P_{ij}|^2 < 16Q$$

$b_{ij} = 0$, falls obige Bedingung nicht erfüllt ist.

Mit dieser Bedingung wird eine Amplitudenbegrenzung durchgeführt, mit der z.B. verhindert wird, daß Division $S_{ij}^P/S_{ij}$ außerhalb des Objekts z.B. aufgrund von Rauschen zu zufälligen, nicht aussagekräftigen Werten führt.

Die exakte Bedingung für die Elimination nicht sinnvoller Werte kann natürlich auch anders gestaltet werden, jedoch hat sich die oben angegebene Bedingung zur Amplitudenbegrenzung als wirksam erwiesen.

In der Matrix mit den Größen $b_{ij}$ wird nun eine Fouriertransformation in Spaltenrichtung durchgeführt (mit $FT_C$ bezeichnet), so daß man schließlich die Bildmatrix B erhält, aufgrund derer ein Bild des untersuchten Objekts aufgebaut werden kann.

Die Signale $S_{ij}$ zur Erstellung der Referenzmatrix MR können beispielsweise in einem vollständigen Anrege-Auslesezyklus gewonnen werden, was allerdings zu einer entsprechenden Verlängerung der Meßzeit führt. Es ist aber auch möglich, die während der Anregephase A gewonnenen Signale S, wie sie beispielsweise in FIG 18 dargestellt sind, zur Erstellung der Referenzmatrix MR zu verwenden, wobei lediglich jegliche Phasencodierung für diese Signale weggelassen wird.

Bei Betrachtung des Amplitudenspektrums der Kernresonanzsignale S kann man feststellen, daß zum einen gewisse Symmetrien vorliegen, und zum anderen unterschiedliche Signale stets dieselbe Amplitude haben oder die Amplituden in einem festen Verhältnis zueinander stehen. Wenn man diese Tatsache ausnutzt, muß man für die Referenzmatrix MR keinen vollständigen Datensatz erstellen, da z.B. nicht gemessene Signale aufgrund der oben genannten Information ergänzt werden können. Damit kann man erhebliche Meßzeit für die Gewinnung der Referenzsignale sparen.

Es ist ferner auch möglich, aufgrund einer einzelnen Referenzmessung die Amplitudenskalierung für die Pulssequenz fest einzustellen.

Es ist darauf hinzuweisen, daß die dargestellten Ausführungsbeispiele nur einzelne Möglichkeiten der Vielzahl von Pulssequenzen zur Realisierung der Erfindung darstellen. Z.B. ist eine Kombination der dargestellten Pulssequenzen möglich. So kann z.B. überall der Phasencodiergradient wie in FIG 27 eingeschaltet bleiben, anstatt in Einzelpulsen realisiert zu werden. Ferner können bei allen Ausführungsbeispielen die Signale S auch durch Inversion des Auslesegradienten gemäß FIG 20 realisiert werden. Auch die Schichtselektion kann sich, wie in FIG 21, auf alle HF-Pulse beziehen.

**Patentansprüche**

1. Verfahren zum Betrieb eines Kernspinresonanzgerätes mit einer Pulssequenz umfassend eine Anregephase (A) und eine nachfolgende Auslesephase (B) mit folgenden Schritten:

   a) während der Anregephase (A) wird eine Folge von Anregepulsen (RF1 bis RF4) einschaltet, wobei zumindest in den Pausen zwischen den Anregepulsen ein erster Gradient (GR1 bis GR4) in einer ersten Richtung eingeschaltet wird und wobei dessen Gradientenflächen zwischen je zwei Anregepulsen (RF1 bis RF4) jeweils verschieden sind;

   b) ein 180°-HF-Puls (RF5) wird eingeschaltet;

   c) während der Auslesephase (B) werden die entstehenden Kernresonanzsignale (S) unter einem Auslesegradienten (GR5) ausgelesen, der zumindest eine Komponente in der ersten Richtung aufweist;

   d) die Kernresonanzsignale (S) werden nach Betrag und Phase analysiert und daraus ein Bild rekonstruiert.

2. Verfahren zum Betrieb eines Kernspinresonanzgerätes mit einer Pulssequenz umfassend eine Anregephase (A) und eine nachfolgende Auslesephase (B) mit folgenden Schritten:

   a) während der Anregephase (A) wird eine Folge von Anregepulsen (RF1 bis RF4) einschaltet, wobei zumindest in den Pausen zwischen den Anregepulsen ein erster Gradient (GR1 bis GR4) in einer ersten Richtung eingeschaltet wird und wobei dessen Gradientenflächen zwischen je zwei Anregepulsen (RF1 bis RF4) jeweils verschieden sind;

   b) -

   c) während der Auslesephase (B) werden die entstehenden Kernresonanzsignale (S) unter einem Gradienten (GR5) ausgelesen, der mindestens eine Komponente entgegengesetzt zur ersten Richtung aufweist,

   d) die Kernresonanzsignale (S) werden nach Betrag und Phase analysiert und daraus ein Bild rekonstruiert.

3. Verfahren nach Anspruch 1 oder 2, **dadurch gekennzeichnet**, daß die Gradientenflächen zwischen den Anregepulsen so verteilt sind, daß sich die zur Bildgebung benutzten Kernresonanzechosignale in der Auslesephase (B) nicht überlagern.

4. Verfahren nach Anspruch 3, **dadurch gekennzeichnet**, daß die Gradientenflächen von Anregepuls zu Anregepuls (RF1 bis RF4) der Größe nach sortiert mindestens mit dem Faktor 3 steigen.

5. Verfahren nach einem der Ansprüche 1 bis 4, **dadurch gekennzeichnet**, daß die Summe der Flipwinkel der während der Anregephase (A) eingestrahlten Anregepulse (RF1 bis RF4) wesentlich größer als 180° ist.

6. Verfahren nach Anspruch 5, **dadurch gekennzeichnet**, daß der Flipwinkel des ersten Anregepulses (RF1) 90° und die Flipwinkel der übrigen Anregepulse zwischen 60° und 90° betragen.

7. Verfahren nach einem der Ansprüche 1 bis 6, **dadurch gekennzeichnet**, daß während Schritt c) ein Phasencodiergradient (GP) senkrecht zur ersten Richtung eingeschaltet wird.

8. Verfahren nach Anspruch 7, **dadurch gekennzeichnet**, daß der Phasencodiergradient (GP) nur zwischen den einzelnen Kernresonanzsignalen (S) eingeschaltet wird.

9. Verfahren nach Anspruch 7, **dadurch gekennzeichnet**, daß der Phasencodiergradient (GP) während der Auslesephase (B) eingeschaltet bleibt.

10. Verfahren nach einem der Ansprüche 1 bis 9, **dadurch gekennzeichnet**, daß während der Anregephase (A) ein Phasencodiergradient (GP1-GP4) senkrecht zur ersten Richtung eingeschaltet wird.

11. Verfahren nach einem der Ansprüche 1 bis 10, **dadurch gekennzeichnet**, daß auch in der Anregephase (A) Signale (S') ausgelesen und zur Bildrekonstruktion verwendet werden.

12. Verfahren nach einem der Ansprüche 1 oder 3 bis 11, **dadurch gekennzeichnet**, daß der 180°-HF-Puls (RF5) frequenzselektiv ist und unter der Einwirkung eines zum ersten Gradienten und ggf. zum Phasencodiergradienten senkrecht stehenden zweiten Gradienten (GS) eingestrahlt wird, so daß nur die Spins in einer selektierten Schicht invertiert werden.

13. Verfahren nach einem der Ansprüche 1 bis 12, **dadurch gekennzeichnet**, daß alle Anregepulse (RF1 bis RF4) schichtselektiv sind.

14. Verfahren nach einem der Ansprüche 1 bis 13, **dadurch gekennzeichnet,** daß die Gradientenflächen des ersten Gradienten zwischen zwei aufeinanderfolgenden Anregepulsen (RF1 bis RF4) ab dem zweiten Anregepuls (RF2) geometrisch ansteigend sind.

15. Verfahren nach einem der Ansprüche 1 bis 14, **dadurch gekennzeichnet**, daß durch Wahl der Flipwinkel der HF-Anregepulse (RF1 bis RF4) eine Optimierung der Amplitudenverteilung der Kernresonanzsignale (S) im k-Raum in der Auslesephase (B) durchgeführt wird.

16. Verfahren nach einem der Ansprüche 1 bis 15, **dadurch gekennzeichnet,** daß die Phasencodierung so gesteuert wird, daß die Amplitudenverteilung im k-Raum optimiert wird.

17. Verfahren nach einem der Ansprüche 1 bis 16, **dadurch gekennzeichnet**, daß durch Einschalten eines zweiten Phasencodiergradienten (GP') senkrecht zum ersten Phasencodiergradienten (GP) und zum Auslesegradienten (GR) zusätzlich eine Phasencodierung in der Richtung des zweiten Phasencodiergradienten (GP') durchgeführt wird, daß der zweite Phasencodiergradient (GP') in n aufeinanderfolgenden Anrege- und Auslesephasen n verschiedene Werte annimmt und daß bei der Bildrekonstruktion eine dreidimensionale Ortsauflösung erfolgt.

18. Verfahren nach einem der Ansprüche 1 bis 16, **dadurch gekennzeichnet**, daß durch Einschalten eines zweiten Phasencodiergradienten (GP') senkrecht zum ersten Phasencodiergradienten (GP) und zum Auslesegradienten (GR) zusätzlich eine Phasencodierung in der Richtung des zweiten Phasencodiergradienten durchgeführt wird, daß der zweite Phasencodiergradient (GP') während einer einzigen Anrege- und Auslesephase mit n verschiedenen Werten derart geschaltet wird, daß die Phase des Kernresonanzsignals in der Richtung des zweiten Phasencodiergradienten (GP') codiert wird und daß bei der Bildrekonstruktion eine dreidimensionale Ortsauflösung erfolgt.

19. Verfahren nach einem der Ansprüche 1 bis 18, **dadurch gekennzeichnet**, daß aus den verschiedenen Kernresonanzsignalen (S) durch unterschiedliche Skalierung in einer Auswerteschaltung Meßsignale mit optimierter Amplitudenverteilung im k-Raum erzeugt werden.

20. Verfahren nach einem der Ansprüche 1 bis 19, **dadurch gekennzeichnet**, daß zwei Sätze von Kernresonanzsignalen gewonnen werden, wovon nur ein Satz phasencodiert ist und daß der nicht phasencodierte Satz von Kernresonanzsignalen als Referenzwert für die Skalierung der Signalamplitude verwendet wird.

21. Verfahren nach Anspruch 20, **dadurch gekennzeichnet**, daß zwei vollständige Pulssequenzen mit Anrege- und Auslesephase durchgeführt werden, wobei einmal die Kernresonanzsignale phasencodiert und einmal nicht phasencodiert werden.

**22.** Verfahren nach Anspruch 20, **dadurch gekennzeichnet,** daß der Satz von nicht phasencodierten Kernresonanzsignalen während der Anregephase gewonnen wird.

**23.** Verfahren nach einem der Ansprüche 1 bis 20, **dadurch gekennzeichnet,** daß unter Ausnutzung von Symmetrien im Amplitudenverlauf der Kernresonanzsignale nur soviele nicht phasencodierte Kernresonanzsignale gewonnen werden, wie für eine Erfassung der Amplitudenverteilung notwendig sind.

**24.** Verfahren nach einem der Ansprüche 1 bis 23, **dadurch gekennzeichnet,** daß der phasencodierte Satz von Kernresonanzsignalen in eine Rohdatenmatrix (M) und der nicht phasencodierte Satz von Kernresonanzsignalen in eine Referenzmatrix (MR) eingetragen wird, daß in beiden Matrizen (M, MR) eine Fourier-Transformation in Ausleserichtung durchgeführt wird, daß jedes einzelne Signal in der aus der Rohdatenmatrix (M) gewonnenen Matrix durch das entsprechende Signal in der aus der Referenzmatrix (MR) gewonnenen Matrix dividiert wird und daß durch Fourier-Transformation in Phasencodierrichtung eine Bildmatrix (B) erstellt wird.

**25.** Verfahren nach einem der Ansprüche 1 oder 3 bis 24, **dadurch gekennzeichnet,** daß nach Schritt c) mindestens ein weiterer 180°-Hf-Puls eingeschaltet wird und daß nach jedem weiteren 180°-Hf-Puls während jeweils einer weiteren Auslesephase (B2) Kernresonanzsignale unter einem Auslesegradienten (GR) erfaßt werden, der zumindest eine Komponente in der ersten Richtung aufweist.

**26.** Verfahren nach Anspruch 25, **dadurch gekennzeichnet,** daß während der weiteren Auslesephasen (B1, B2) ein Phasencodiergradient (GP) eingeschaltet wird, dessen Vorzeichen von Auslesephase zu Auslesephase wechselt.

**27.** Verfahren nach einem der Ansprüche 1 bis 24, **dadurch gekennzeichnet,** daß nach Schritt c) der Auslesegradient mindestens einmal umgekehrt wird und daß während mindestens einer weiteren Auslesephase Kernresonanzsignale unter der Wirkung des Auslesegradienten erfaßt werden.

**28.** Verfahren nach Anspruch 27, **dadurch gekennzeichnet,** daß während jeder Auslesephase (B1, B2) ein Phasencodiergradient eingeschaltet ist.

## Claims

**1.** Method for operating a nuclear magnetic resonance apparatus with a pulse sequence comprising an excitation phase (A) and a subsequent read-out phase (B), having the following steps:
(a) a sequence of excitation pulses (RF1 to RF4) is activated during the excitation phase (A), wherein a first gradient (GR1 to GR4) is activated in a first direction at least in the pauses between the excitation pulses and wherein the gradient areas of this first gradient are respectively different between each two excitation pulses (RF1 to RF4);
(b) a 180° radio frequency pulse (RF5) is activated:
(c) the resulting nuclear magnetic resonance signals (S) are read out during the read-out phase (B) under a read-out gradient (GR5) which has at least one component in the first direction;
(d) the nuclear magnetic resonance signals (S) are analyzed according to amplitude and phase and an image is reconstructed therefrom.

**2.** Method for operating a nuclear magnetic resonance apparatus with a pulse sequence comprising an excitation phase (A) and a subsequent read-out phase (B), having the following steps:
(a) a sequence of excitation pulses (RF1 to RF4) is activated during the excitation phase (A), wherein a first gradient (GR1 to GR4) is activated in a first direction at least in the pauses between the excitation pulses and wherein the gradient areas of this first gradient are respectively different between each two excitation pulses (RF1 to RF4);
(b) -
(c) the resulting nuclear magnetic resonance signals (S) are read out during the read-out phase (B) under a gradient (GR5) which has at least one component in the direction opposite the first direction;
(d) the nuclear magnetic resonance signals (S) are analyzed according to amplitude and phase and an image is reconstructed therefrom.

3.  Method according to claim 1 or 2, characterised in that the gradient areas between the excitation pulses are distributed so that the nuclear magnetic resonance echo signals used for imaging are not superimposed in the read-out phase (B).

4.  Method according to claim 3, characterised in that the gradient areas increase at least by a factor of 3 from excitation pulse to excitation pulse (RF1 to RF4), sorted according to size.

5.  Method according to one of claims 1 to 4, characterised in that the sum of the flip angles of the excitation pulses (RF1 to RF4) used during the excitation phase (A), is significantly greater than 180°.

6.  Method according to claim 5, characterised in that the flip angle of the first excitation pulse (RF1) is 90° and the flip angles of the remaining excitation pulses are between 60° and 90°.

7.  Method according to one of claims 1 to 6, characterised in that, during step (c), a phase-coding gradient (GP) is activated in a direction perpendicular to the first direction.

8.  Method according to claim 7, characterised in that the phase-coding gradient (GP) is activated only between the individual nuclear magnetic resonance signals (S).

9.  Method according to claim 7, characterised in that the phase-coding gradient (GP) remains activated during the read-out phase (B).

10. Method according to one of claims 1 to 9, characterised in that, during the excitation phase (A), a phase-coding gradient (GP1 to GP4) is activated in a direction perpendicular to the first direction.

11. Method according to one of claims 1 to 10, characterised in that signals (S') are also read out in the excitation phase (A) and are used for image reconstruction.

12. Method according to one of claims 1 or 3 to 11, characterised in that the 180° radio frequency pulse (RF5) is frequency-selective and is used under the effect of a second gradient (GS) disposed perpendicular to the first gradient and possibly to the phase-coding gradient, so that only the spins in a selected slice are inverted.

13. Method according to one of claims 1 to 12, characterised in that all of the excitation pulses (RF1 to RF4) are slice-selective.

14. Method according to one of claims 1 to 13, characterised in that the gradient areas of the first gradient increase geometrically between two successive excitation pulses (RF1 to RF4) after the second excitation pulse (RF2).

15. Method according to one of claims 1 to 14, characterised in that optimization of the amplitude distribution of the nuclear magnetic resonance signals (S) in the k-space during the read-out phase (B) is implemented by selection of the flip angles of the radio frequency excitation pulses (RF1 to RF4).

16. Method according to one of claims 1 to 15, characterised in that the phase coding is controlled so that the amplitude distribution in the k-space is optimised.

17. Method according to one of claims 1 to 16, characterised in that, by activating a second phase-coding gradient (GP') in a direction perpendicular to the first phase-coding gradient (GP) and to the readout gradient (GR), a phase coding is additionally implemented in the direction of the second phase-coding gradient (GP'), in that the second phase-coding gradient (GP') assumes n different values in n successive excitation and read-out phases, and in that three-dimensional topical resolution ensues during the image reconstruction.

18. Method according to one of claims 1 to 16, characterised in that, by activating a second phase-coding gradient (GP') in a direction perpendicular to the first phase-coding gradient (GP) and to the readout gradient (GR), a phase-coding is additionally implemented in the direction of the second phase-coding gradient, in that the second phase-coding gradient (GP') is switched with n different values during a single excitation and read-out phase in such a way that the phase of the nuclear magnetic resonance signal is coded in the direction of the second phase-coding gradient (GP'), and in that three-dimensional topical

12

resolution ensues during image reconstruction.

19. Method according to one of claims 1 to 18, characterised in that measuring signals with optimised amplitude distribution in the k-space are generated from the different nuclear magnetic resonance signals (S) by variable scaling in an evaluation circuit.

20. Method according to one of claims 1 to 19, characterised in that there are obtained two sets of nuclear magnetic resonance signals, only one of these sets being phase-coded, and in that the non-phase-coded set of nuclear magnetic resonance signals is used as a reference value for the scaling of the signal amplitude.

21. Method according to claim 20, characterised in that two complete pulse sequences having an excitation and read-out phase are implemented, the nuclear magnetic resonance signals being sometimes phase-coded and sometimes not phase-coded.

22. Method according to claim 20, characterised in that the set of non-phase-coded nuclear magnetic resonance signals is obtained during the excitation phase.

23. Method according to one of claims 1 to 20, characterised in that, utilizing symmetries in the amplitude curve of the nuclear magnetic resonance signals, there are obtained only as many non-phase-coded nuclear magnetic resonance signals as are necessary for acquisition of the amplitude distribution.

24. Method according to one of claims 1 to 23, characterised in that the phase-coded set of nuclear magnetic resonance signals is entered in a raw data matrix (M) and the non-phase-coded set of nuclear magnetic resonance signals is entered in a reference matrix (MR), in that a Fourier transformation is undertaken in the read-out direction in both matrices (M, MR), in that each individual signal in the matrix obtained from the raw data matrix (M) is divided by the corresponding signal in the matrix obtained from the reference matrix (MR), and in that an image matrix (B) is created by Fourier transformation in the phase-coding direction.

25. Method according to one of claims 1 or 3 to 24, characterised in that at least one further 180° radio frequency pulse is activated after step (c) and in that nuclear magnetic resonance signals are acquired during a respective further read-out phase (B2) after each further 180° radio frequency pulse under a readout gradient (GR) which has at least one component in the first direction.

26. Method according to claim 25, characterised in that a phase-coding gradient (GP) having an operational sign which changes from read-out phase to read-out phase is activated during the further read-out phases (B1, B2).

27. Method according to one of claims 1 to 24, characterised in that the read-out gradient is inverted at least once after step (c), and in that nuclear magnetic resonance signals are acquired during at least one further read-out phase under the effect of the read-out gradient.

28. Method according to claim 27, characterised in that a phase-coding gradient is activated during each read-out phase (B1, B2).

## Revendications

1. Procédé pour exploiter un appareil à résonance magnétique nucléaire avec une séquence d'impulsions, comprenant une phase d'excitation (A) et une phase suivante de lecture (B), avec les étapes suivantes :
   a) pendant la phase d'excitation (A), on applique une suite d'impulsions d'excitation (F1 à F4), un premier gradient (GR1 à GR4) étant appliqué dans une première direction au moins pendant les pauses entre les impulsions d'excitation et les surfaces de ce gradient étant respectivement différentes entre deux impulsions respectives d'excitation (FR1 à FR4);
   b) on applique une impulsion HF à 180° (RF5);
   c) pendant la phase de lecture (B), on lit les signaux de résonance nucléaire apparus (S), sous un gradient de lecture (GR5), qui possède au moins une composante dans la première direction;
   d) on analyse les signaux de résonance nucléaire (S), du point de vue valeur absolue et phase, et à

EP 0 560 168 B1

partir de là, on reconstitue une image.

2. Procédé pour exploiter un appareil à résonance magnétique nucléaire avec une séquence d'impulsions, comprenant une phase d'excitation (A) et une phase suivante de lecture (B), avec les étapes suivantes :

a) pendant la phase d'excitation (A), on applique une suite d'impulsions d'excitation (F1 à F4), un premier gradient (GR1 à GR4) étant appliqué dans une première direction au moins pendant les pauses entre les impulsions d'excitation et les surfaces de ce gradient étant respectivement différentes entre deux impulsions respectives d'excitation (FR1 à FR4);

b) -

c) pendant la phase de lecture (B), on lit les signaux de résonance nucléaire apparus (S), sous un gradient de lecture (GR5), qui possède au moins une composante en sens opposé de la première direction;

d) on analyse les signaux de résonance nucléaire (S), du point de vue valeur absolue et phase, et à partir de là, on reconstitue une image.

3. Procédé suivant la revendication 1 ou 2, caractérisé par le fait que les surfaces du gradient entre les impulsions d'excitation sont réparties de telle sorte que les signaux d'échos de résonance nucléaire, utilisés pour la formation de l'image, ne se superposent pas pendant la phase de lecture (B).

4. Procédé suivant la revendication 3, caractérisé par le fait que les surfaces de gradient augmentent au moins du facteur 3, en étant triées en fonction de la taille, d'une impulsion d'excitation (FR1 à FR4) à la suivante.

5. Procédé suivant l'une des revendications 1 à 4, caractérisé par le fait que la somme de l'angle de basculement (flip) des impulsions d'excitation (F1 à F4), introduites pendant la phase d'excitation (A), est nettement supérieure à 180°.

6. Procédé suivant la revendication 5, caractérisé par le fait que l'angle de basculement de la première impulsion d'excitation (RF1) est égal à 90° et que l'angle de basculement des autres impulsions d'excitation est compris entre 60° et 90°.

7. Procédé suivant l'une des revendications 1 à 6, caractérisé par le fait que pendant l'étape c), on applique un gradient de codage de phase (GP) perpendiculairement à la première direction.

8. Procédé suivant la revendication 7, caractérisé par le fait qu'on applique le gradient de codage de phase (GP) uniquement entre les différents signaux de résonance nucléaire (S).

9. Procédé suivant la revendication 7, caractérisé par le fait que le gradient de codage de phase (GP) reste appliqué pendant la phase de lecture (B).

10. Procédé suivant l'une des revendications 1 à 9, caractérisé par le fait que pendant la phase d'excitation (A), on applique un gradient de codage de phase (GP1-GP4) perpendiculairement à la première direction.

11. Procédé suivant l'une des revendications 1 à 10, caractérisé par le fait que également pendant la phase d'excitation (11), des signaux (S') sont lus et sont utilisés pour la reconstitution de l'image.

12. Procédé suivant l'une des revendications 1 ou 3 à 11, caractérisé par le fait que l'impulsion HF à 180° (RF5) est sélective du point de vue de la fréquence et est émise sous l'action d'un second gradient (GS) perpendiculaire au premier gradient et éventuellement au gradient de codage de phase, de sorte que seuls les spins sont inversés dans une couche sélectionnée.

13. Procédé suivant l'une des revendications 1 à 12, caractérisé par le fait que toutes les impulsions d'excitation (RF1 à RF4) sont sélectives du point de vue des couches.

14. Procédé suivant l'une des revendications 1 à 13, caractérisé par le fait que les surfaces du premier gradient sont en progression géométrique entre deux impulsions successives d'excitation (RF1 à RF4), à partir de la seconde impulsion d'excitation (RF2).

15. Procédé suivant l'une des revendications 1 à 13, caractérisé par le fait que grâce au choix de l'angle de basculement des impulsions d'excitation HF (RF1 à RF4), on exécute une optimisation de la distribution d'amplitude des signaux de résonance nucléaire (RS) dans l'espace k pendant la phase de lecture (B).

14

**16.** Procédé suivant l'une des revendications 1 à 15, caractérisé par le fait que le codage de phase est commandé de telle sorte que la distribution d'amplitude est optimisée dans l'espace k.

**17.** Procédé suivant l'une des revendications 1 à 16, caractérisé par le fait que grâce à l'application d'un second gradient de codage de phase (GP') perpendiculairement au premier gradient de codage de phase (GP) et au gradient de lecture (GR), on exécute, en supplément, un codage de phase dans la direction du second gradient de codage de phase (GP'), que le second gradient de codage de phase (GP') prend n valeurs différentes pendant n phases successives d'excitation et de lecture, et que lors de la reconstitution d'une image, une résolution locale tridimensionnelle est exécutée.

**18.** Procédé suivant l'une des revendications 1 à 16, caractérisé par le fait que sous l'effet de l'application d'un second gradient de codage de phase (GP') perpendiculairement au premier gradient de codage de phase (GP) et au gradient de lecture (GR), on applique, en supplément, un codage de phase dans la direction du second gradient de codage de phase, que le second gradient de codage de phase (GP') est appliqué pendant une seule phase d'excitation et de lecture avec n valeurs différentes, de sorte que la phase du signal de résonance nucléaire est codée dans la direction du second gradient de codage de phase (GP), et que lors de la reconstitution de l'image, on obtient une résolution locale tridimensionnelle.

**19.** Procédé suivant l'une des revendications 1 à 18, caractérisé par le fait que des signaux de mesure possédant une distribution d'amplitude optimisée sont produits dans l'espace k, au moyen d'un cadrage d'échelle différent, à partir des différents signaux de résonance nucléaire (S).

**20.** Procédé suivant l'une des revendications 1 à 19, caractérisé par le fait qu'on obtient deux ensembles de signaux de résonance nucléaire, dont seul un ensemble est codé selon un codage de phase et que l'ensemble, non codé selon un codage de phase, de signaux de résonance nucléaire est utilisé en tant que valeur de référence pour le cadrage d'échelle de l'amplitude des signaux.

**21.** Procédé suivant la revendication 20, caractérisé par le fait qu'on forme deux séquences complètes d'impulsions possédant une phase d'excitation et une phase de lecture, les signaux de résonance nucléaire étant une fois codés, une fois non codés selon un codage de phase.

**22.** Procédé suivant la revendication 20, caractérisé par le fait que l'ensemble de signaux de résonance nucléaire, non codés selon un codage de phase, est obtenu pendant la phase d'excitation.

**23.** Procédé suivant l'une des revendications 1 à 20, caractérisé par le fait que dans le cas de l'utilisation de symétries dans la variation d'amplitude des signaux de résonance nucléaire, on obtient juste le nombre de signaux de résonance nucléaire non codés selon un codage de phase, qui est nécessaire pour une détection de la distribution d'amplitude.

**24.** Procédé suivant l'une des revendications 1 à 23, caractérisé par le fait que l'ensemble, codé selon un codage de phase, de signaux de résonance nucléaire est introduit dans une matrice de données brutes (M), et l'ensemble, non codé selon un codage de phase, de signaux de résonance nucléaire est introduit dans une matrice de référence (MR), qu'une transformation de Fourier est exécutée dans le sens de la lecture dans les deux matrices (M, MR), que chaque signal individuel dans la matrice obtenue à partir de la matrice de données brutes (M) est divisé par le signal correspondant présent dans la matrice obtenue à partir de la matrice de référence (MR) et qu'une matrice d'image (B) est établie au moyen d'une transformation de Fourier dans le sens du codage de phase.

**25.** Procédé suivant l'une des revendications 1 ou 3 à 24, caractérisé par le fait qu'après l'étape c), au moins une autre impulsion Hf à 180° est appliquée et qu'après chaque autre impulsion Hf à 180°, des signaux de résonance nucléaire sont détectés pendant respectivement une autre phase de lecture (B2), sous un gradient de lecture (GR), qui possède au moins une composante dans la première direction.

**26.** Procédé suivant la revendication 25, caractérisé par le fait que pendant les autres phases de lecture (B1,B2) on applique un gradient de codage de phase (GP), dont le signe change d'une phase de lecture à la suivante.

**27.** Procédé suivant l'une des revendications 1 à 24, caractérisé par le fait qu'après l'étape c), le gradient de lecture est inversé au moins une fois et que pendant au moins une autre phase de lecture, des signaux de résonance nucléaire sont détectés sous l'action du gradient de lecture.

28. Procédé suivant la revendication 27, caractérisé par le fait qu'un gradient de codage de phase est appliqué pendant chaque phase de lecture (B1,B2).

EP 0 560 168 B1

RF1  RF2  RF3              RF4                              RF5
90°  α₁   α₂               α₃                               180°

RF

**FIG 1**

GR1  GR2   GR3        GR4                    GR5

GR

**FIG 2**

GS

**FIG 3**

GPV

GP

**FIG 4**

S

**FIG 5**

t1 t2   t3          t4              t5

A     B

FIG 6

FIG 7

FIG 8

FIG 9

FIG 12

FIG 11

FIG 10

FIG 13

RF  RF1  RF2  RF3  RF4  RF5
    90°  $\alpha_1$  $\alpha_2$  $\alpha_3$  180°

GP  GP1  GP2  GP3  GP4

GS

GR

A  B

S

t1  t2  t3  t4  t5

21

RF1  RF2   RF3                    RF4                              RF5
90°   $\alpha_1$    $\alpha_2$                     $\alpha_3$                            180°

RF

**FIG 14**

GR1   GR2      GR3              GR4                    GR5

GR

**FIG 15**

GS

**FIG 16**

GP

GPV

**FIG 17**

S

t5

A        B

**FIG 18**

RF1 RF2 RF3                    RF4

90°  α₁    α₂                    α₃

RF

FIG 19

GR1  GR2      GR3          GR4

GR

GR5

FIG 20

GS

FIG 21

GP

GPV

FIG 22

S

FIG 23

t1  t2    t3          t4              t5

A        B

EP 0 560 168 B1

EP 0 560 168 B1

RF1  RF2     RF3                    RF4                              RF5
90°   $\alpha_1$    $\alpha_2$                     $\alpha_3$                             180°

RF

**FIG 24**

GR1        GR2          GR3              GR4                    GR5

GR

**FIG 25**

GPS
GS
GP

GPS         GS

**FIG 26**

GPV          GP

GP

**FIG 27**

S

t1  t2    t3                      t4                                      t5

**FIG 28**

A        B

GR

FIG 29

GP'

FIG 30

GP

FIG 31

S

FIG 32

FIG 34

FIG 35

FIG 36

FIG 37

FIG 33

FIG 39

FIG 40

FIG 41

FIG 42

FIG 38

$S_{ij}$

$S_{ij}^{P}$

MR

M

$FT_L$

$FT_L$

$$\overline{S_j} = \frac{\sum\limits_{i=1}^{M} |S_{ij}|}{M}$$

$$P_{ij} = \frac{S_{ij}^{P}}{S_{ij}}$$

$\overline{S_K} = \max \overline{S_j}$
für $j = 1....N$
$Q = \max |P_{iK}|^2$
für $i = 1....M$

$$b_{ij} = \begin{cases} P_{ij} \cdot \overline{S_j} \text{ für } |P_{ij}|^2 \leq 16Q \\ 0 \text{ sonst} \end{cases}$$

$FT_C$

B

FIG 43